# EUROPEAN PATENT APPLICATION

(11) **EP 3 035 709 A1**
(43) Date of publication of application: **22.06.2016**
(21) Application number: 14460119.2
(22) Date of filing: 18.12.2014
(51) Int. Cl.: H04R 19/04, H04R 7/00, H04R 7/04

(54) **Condenser microphone**

(71) Applicant: Nawrocki, Piotr, 88-100 Inowroclaw (PL)
(72) Inventor: Nawrocki, Piotr, 88-100 Inowroclaw (PL)
(74) Representative: Sielewiesiuk, Jakub

(57) **Abstract**

The object of the present invention is a condenser microphone comprising a moveable lining and a fixed lining connected to the power supply and the amplifier, wherein the movable lining comprises graphene and the fixed one is a fixed plate, characterized in that graphene is in the form of at least one layer.

## Description

The object of the invention is a condenser microphone, especially for use in studios, but also on the scene, as the central microphone for drums and to reinforce the sound of orchestras or choirs.

A microphone is an electroacoustic transducer changing the sound wave energy into electricity. The conversion of this energy may be performed in different ways (hence the different types of microphones). The microphone is typically the first element of an audio track.

Microphones can be classified:
- due to the way of processing the membrane vibrations into an electrical signal;
- due to the nature of the sound field effects on the membrane;
- due to the application.

Due to the way of processing vibrations of the membrane the following can be distinguished:
- carbon microphone;
- piezoelectric microphone;
- dynamic microphone;
- condenser microphone (electret / large-diaphragm / small-diaphragm / surface);
- experimental microphones.

A condenser microphone was invented at Bell Labs in 1916. Its structure consists of two electrodes (pads). One of these is stationary while the other acts as a diaphragm and is exposed to acoustic waves. Movement of the diaphragm creates a variable component in the DC voltage of the capacitor, reflects the frequency of the acoustic wave incident on the microphone. For this design to work, the voltage of 48V is necessary (i.e. a phantom and it is provided with a battery or a microphone cable). Depending on whether the polarization requires an external microphone, or not, condenser microphones are divided into those of external polarization and electret microphones. Both types require power, as an integral part of the microphone is a three-microphone amplifier. To be precise, we should speak about an electret microphone insert and one powered externally.

In the case of making high quality recording of voice or sound of the choir (or any other group of people singing), strings or metal drums, a condenser microphone is used. This happens for two reasons: these microphones have a generally wider and more even frequency range than dynamic microphones of comparable quality, they have a wide bandwidth and above all, have a higher voltage sensitivity. Because of their sensitivity to loud noise compared with dynamic microphones, they are used predominantly in the studios.

In the prior art publication CN103557929 (A) a method for making a membrane comprising graphene is known. The membrane thus produced is used as an element of the optical fiber which are the acoustic pressure sensors.

The publication KR101058475 (B1) discloses a MEMS microphone comprising a graphene diaphragm structure and a method of manufacture of graphene layers on the surface of the fixed electrode covered with polysilicone.

An object of the present invention is a condenser microphone comprising a moveable pad and a fixed pad connected to the power supply and the amplifier, wherein the movable pad comprises graphene and the fixed one is a fixed plate, characterized in that graphene is in the form of at least one layer.

Preferably graphene is present in doped form.

Preferably, the movable liner comprises a layer of graphene and a layer of adhesive, wherein the graphene layer is in direct contact with the adhesive layer.

Preferably, the adhesive is a polymer.

Preferably, the movable pad comprises a layer of graphene, and two layers of adhesive, wherein the graphene layer is located directly between the two layers of adhesive.

Preferably, the graphene is in a two-dimensional form, single-layer or more such layers.

In another preferred embodiment graphene is in the form of nanotubes, arranged substantially parallel to the surface of the movable pad or arranged substantially perpendicular to the surface of the movable pad.

Preferably, the fixed pad is provided with grooves.

Preferably, the movable pad is placed between two fixed pads.

Preferably, from the movable pad and the fixed pad or the fixed pads only the movable pad comprises at least one layer of graphene.

### Preferred embodiments of the invention

The invention will now be further described in the preferred embodiments, with reference to the accompanying drawings, in which:

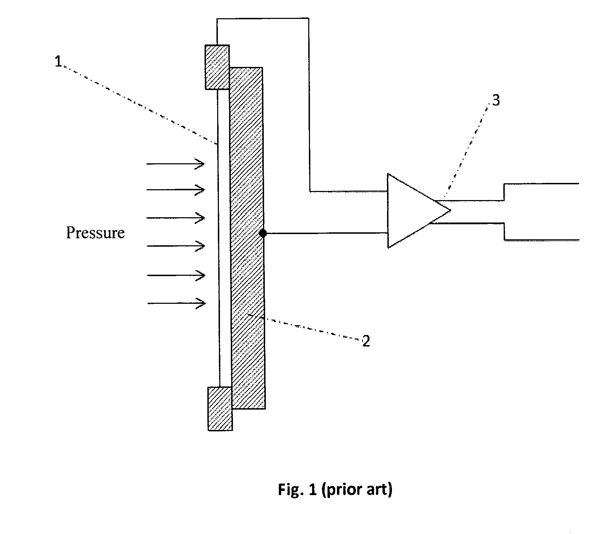

- Fig. 1: illustrates the construction of a condenser microphone of the prior art,
- Fig. 2: illustrates the construction of the movable pad 1 in the capacitor microphone according to the invention,
- Fig. 3: illustrates the use of the movable pad 1 containing graphene G in a condenser microphone according to the invention with external power supply - phantom,
- Fig. 4: illustrates the use of the movable pad 1 containing graphene G in an omnidirectional condenser microphone according to the invention,
- Fig. 5: illustrates the use of the movable pad 1 containing graphene G in a bi-directional condenser microphone according to the invention,
- Fig. 6: illustrates the use of the movable pad 1 containing graphene G in a unidirectional condenser microphone according to the invention, and
- Fig. 7: illustrates examples of the structures of the movable pad 1 in the capacitor microphone according to the invention,

The figures use the following indications: 1 - movable pad (membrane), 2 - fixed pad, 3 - power supply and amplifier, G - graphene, DG - doped graphene, P - polymer.

The present invention relates to a condenser microphone with a moveable pad 1, so called membrane containing graphene G.

The first component of the mobile pad 1 is graphene G in the form of a monatomic conductive layer. It has all the properties corresponding to the requirements of the production of a movable pad 1 of a condenser microphone, including:
- very good electrical conductivity,
- strength,
- a structure of monatomic thickness.

The second component of the movale pad 1 is adhesive of any polymer which ensures consistency, hardness, flexibility and resistance to compression of the movable pad 1.

The structure of the movable pad 1 of a condenser microphone takes into account:
- applying more layers of graphene G in the movable pad 1, thus allowing for changes in the characteristics of the microphone.
- the use of graphene in the form of nanotubes, if the use of the properties of graphene G, which are given by such construction are necessary to increase the effectiveness of the membrane.
- doping of graphene G to modify some properties of the material, e.g.: electrical, or mechanical.

Movable pad 1 of a condenser microphone according to the invention is characterized by a structure selected from the following:
- graphene G layer (two-dimensional or nanotubes structure),
- a layer of graphene G (two-dimensional or of nanotubes structure) between the two polymer layers with contact leads 5 to the surface of one of the two polymer layers,
- a layer of graphene G (two-dimensional or of nanotubes structure)"embedded" on the surface of a single layer of polymer,
- doped graphene DG layer (two-dimensional or of nanotubes structure)
- a doped layer of graphene DG (two-dimensional or of nanotubes structure) between the two polymer layers with contact leads 5 to the surface of one of the two polymer layers,
- a doped layer of graphene DG (two-dimensional or of nanotubes structure) "embedded" on the surface of a single layer of polymer.

In the above embodiments of the construction of the movable 1 pad, graphene G 1 is in the two-dimensional form forming a monatomic layer or several such layers, or is in the form of nanotubes arranged in such a way that they form a single layer structure or are arranged perpendicular to the surface of the movable pad 1 forming a three-dimensional layer.

Movable pad 1 of condenser microphone according to the invention, through the use of graphene G is light, which ensures accurate reproduction of high frequencies. The high strength of graphene G also allows for the creation of relatively large membranes, making it possible to play high quality bass sound. In addition, a light membrane requires little power to operate. The use of graphene membranes in capacitive microphones allows to increase the quality characteristics.

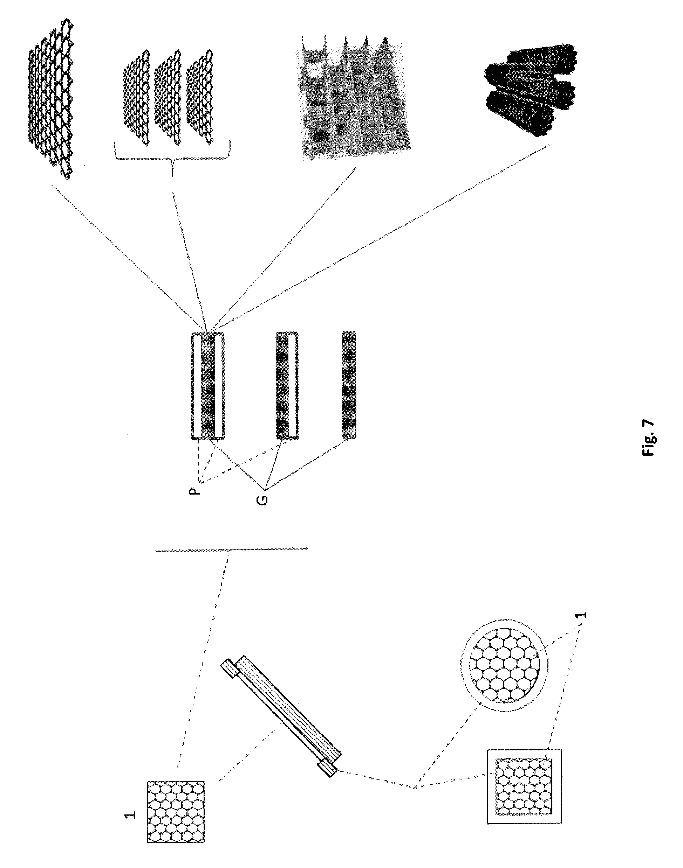

A graphene layer can be used in different configurations in condenser microphones according to the invention. Depending on the design, arrangement of graphene G in the structure of the movable pad 1 may take any form capable of producing the most favorable characteristics. Examples of alignment of the movable pad structures 1 are illustrated in Fig. 7.

### Example 1 - a condenser microphone of the present invention

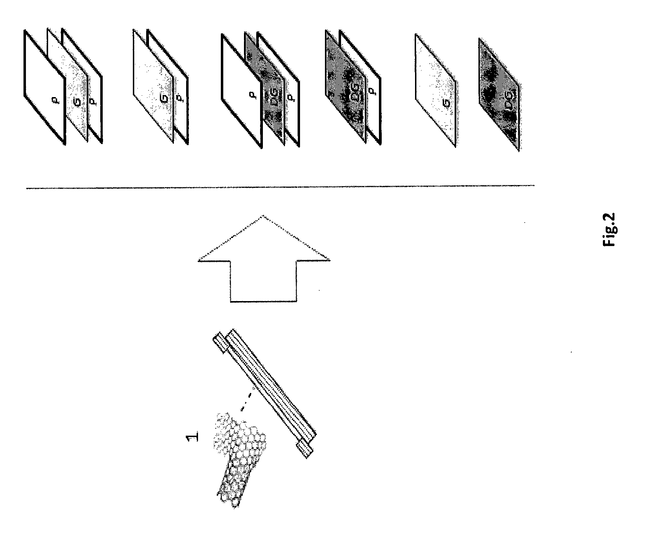

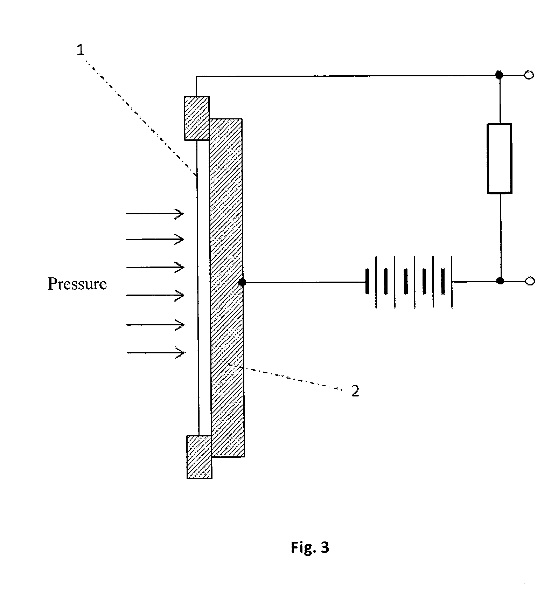

In the present embodiment, the condenser microphone illustrated in the diagram in Fig. 3, has a light moveable pad 1 (the membrane) of graphene G and is built in the form of a capacitor. The second pad, i.e. the fixed pad 2 is a stationary plate. The flexible material of the movable pad 1 has a structure composed of two components having different characteristics: monatomic layer of graphene G and a layer of adhesive, here a polymer P, forming the 2-layer structure G/P, as illustrated in Fig. 2. The properties of the composites are neither the sum nor the average of the properties of its components, and the material 3 used exhibits anisotropy of physical properties of both materials in its construction. Use of the polymer P further provides consistency and elasticity of the movable pad 1.

### Example 2 - application of graphene layers in a microphone with external power supply - phantom.

In the present embodiment, the condenser microphone illustrated in the diagram in Fig. 3 is constructed in such a way that the movable pad 1 and the fixed pad 2 are connected via a high resistance resistor to battery terminals, providing a source of bias voltage. This resistor has a dual role here: in standby mode, when no sound wave falls on the moveable pad 1, it prevents the discharge of the capacitor, and when sound wave falls on the microphone, the movable pad 1 moves under the sound pressure on the surface and vibrates around the standby position. The capacity of pad 1 changes, the charging (and discharging power) flows through the resistor, and variable voltage drop is formed between the resistor terminals. The pad 1 itself can be seen as a source of electromotive force. It is the greater, the greater the amplitude of excursion of the movable pad 1 relative to the distance to the fixed pad 2, and the greater the bias voltage.

### Example 3 - the application of the graphene layer in an omnidirectional condenser microphone.

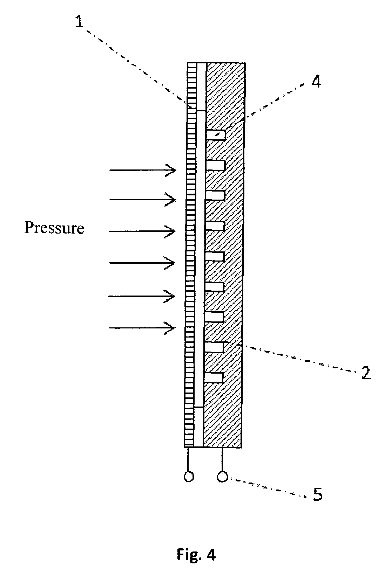

In the present embodiment, the omnidirectional condenser microphone illustrated in the diagram in Fig. 4, is constructed in such a way that the movable pad 1 is adjacent to the fixed pad 2, which is in the form of a flat plate with grooves 4 (drillings). The grooves 4 are meant to increase the susceptibility of the space between the pads and to reduce the frictional resistance of air on the pads. In order to obtain a large deflection of the membrane, and therefore high efficiency, the susceptibility of the system is high. This effect is achieved with the smallest possible weight of the movable pad 1. The shape of the cap is important for the course of the characteristics of the level of effectiveness (in the case of a small-membrane microphone) and the capsule (so called pitch of the capsule in the case of large-membrane microphones) and the shape and size of openings in the cap or capsule. By proper selection of these parameters the deficiencies in performance characteristics can be compensated for. The characteristics of the directivity of the microphone is also associated with the size of the microphone.

### Example 4 - the application of the graphene layer in a bi-directional condenser microphone.

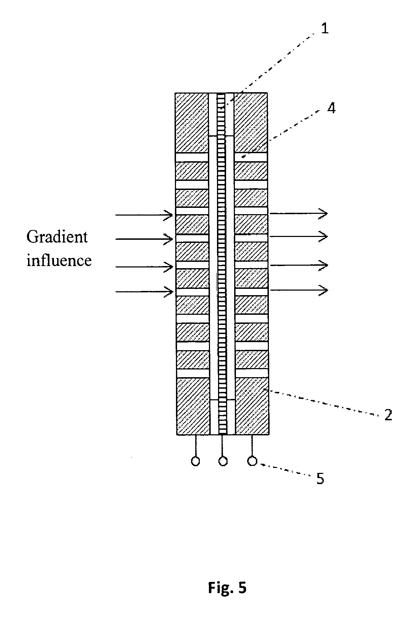

In the present embodiment, the bi-directional condenser microphone illustrated in the diagram in Fig. 5, has an octal characteristic, and the movable pad 1 is disposed between the two fixed pads 2, having a plurality of openings connecting the space surrounding the moveable pad 1 with the atmosphere. Upon incidence of acoustic waves perpendicular to the moveable pad 1, the pressure differential is the greatest and upon the tangential incidence - zero. A condenser microphone of octal characteristics, arranged at a short distance from the source enhances low frequencies and to eliminate the impact of this phenomenon correction must be applied to undercut slightly the bottom of the band.

### Example 5 - the application of the graphene layer in a unidirectional condenser microphone.

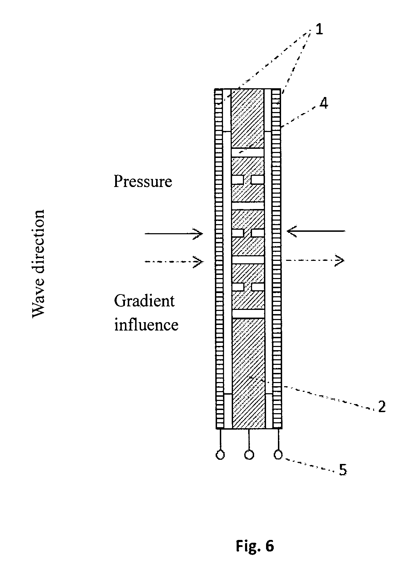

In the present embodiment, the unidirectional condenser microphone illustrated in the diagram in Fig. 6, on both sides of the fixed pad 2, having a series of grooves 4, two movable pads 1 are disposed, only one of which is electrically open. When an acoustic wave falls on the microphone, both moving pads 1 are subjected to forces derived from the sound pressure and the pressure gradient. The forces from the pressure of work on movable pads 1 in opposite directions, trying to move them closer or further of each other. The forces derived from the pressure gradient move both movable pads 1 in the same direction. In this way the forces from the gradient and pressure operate the moveable pad 1 facing the wave in the same direction and are added up and the opposite movable pad 1 in the opposite directions, and are subtracted.

## Claims

1. A condenser microphone comprising a moveable pad (1) and a fixed pad (2), connected to the power supply and an amplifier (3), wherein the movable pad (1) comprises graphene (G) and the fixed pad (2) is a fixed plate **characterized in that** graphene (G) is in the form of at least one layer.

2. Microphone according to claim 1, **characterized in that** graphene (G) is in the doped form (DP).

3. Microphone according to claim 1 or 2, **characterized in that** the movable pad (1) comprises a layer of graphene, and a layer of adhesive, wherein the graphene layer (G) is in direct contact with the layer of adhesive.

4. The microphone according to any one of the preceding claims 1 to 3, **characterized in that** the adhesive is a polymer (P).

5. The microphone according to any one of the preceding claims 1 to 4, **characterized in that** the movable pad (1) comprises a layer of graphene and two layers of adhesive, wherein the graphene layer (G) is located directly between the two layers of polymer (P).

6. The microphone according to any one of the preceding claims 1 to 5, **characterized in that** graphene (G) is in the two-dimensional form, a single-layer or more such layers.

7. The microphone according to any one of the preceding claims 1 to 5, **characterized in that** the graphene (G) is in the form of nanotubes arranged substantially parallel to the surface of the movable pad (1) and arranged substantially perpendicular to the surface of the movable pad (1).

8. The microphone according to any one of the preceding claims 1 to 7, **characterized in that** the fixed pad (2) is provided with grooves (4).

9. The microphone according to any one of the preceding claims 1 to 8, **characterized in that** the movable pad (1) is arranged between the two fixed pads (2).

10. The microphone according to any one of the preceding claims 1 to 9, **characterized in that** among the movable pad (1) and the fixed pad (2) or the fixed pads (2) only the movable pad (1) comprises at least one layer of graphene (G).
